# EUROPEAN PATENT SPECIFICATION

(11) **EP 1 339 110 B1**
(45) Date of publication and mention of the grant of the patent: **28.05.2008**
(21) Application number: 02425087.0
(22) Date of filing: 20.02.2002
(51) Int. Cl.: H01L 45/00, H01L 27/24

(54) **Phase change memory cell and manufacturing method thereof using minitrenches**
Phasenwechsel-Speicherzelle sowie deren Herstellungsverfahren mittels Minigräben
Cellule mémoire à changement de phase et sa méthode de fabrication utilisant des minitranchées

(43) Date of publication of application: 27.08.2003
(73) Proprietor: STMicroelectronics S.r.l., 20041 Agrate Brianza MI (IT); Ovonyx Inc., Rochester Hills, MI 48309 (US)
(72) Inventor: Bez, Roberto, 20146 Milano (IT); Pellizzer, Fabio, 31051 Follina (IT); Tosi, Marina, 20056 Trezzo Sull'adda (IT); Zonca, Romina, 20067 Paullo (IT)
(74) Representative: Cerbaro, Elena

(56) References cited:
- WO-A-02/09206
- US-A- 6 031 287
- US-A1- 2002 017 701

## Description

The present invention relates to a phase change memory cell and to a manufacturing process thereof.

As is known, phase change memory (PCM) elements exploit the characteristics of materials which have the property of changing between two phases having distinct electrical characteristics. For example, these materials may change from an amorphous phase, which is disorderly, to a crystalline or polycrystalline phase, which is orderly, and the two phases are associated to considerably different resistivity.

At present, alloys of group VI of the periodic table, such as Te or Se, referred to as chalcogenides or chalcogenic materials, can advantageously be used in phase change cells. The chalcogenide that currently offers the most promise is formed by a Ge, Sb and Te alloy (Ge₂Sb₂Te₅), which is currently widely used for storing information in overwritable disks.

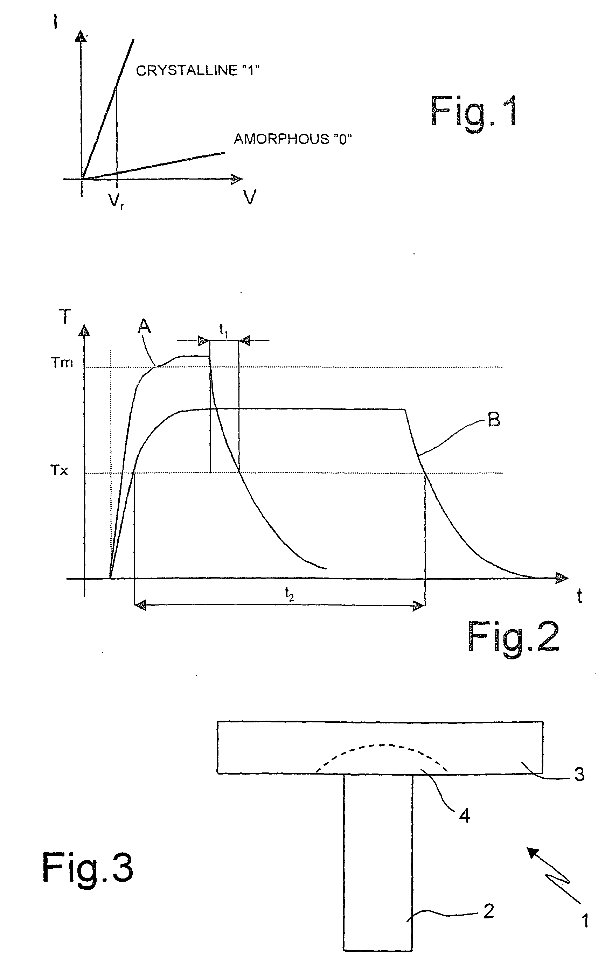

In chalcogenides, the resistivity varies by two or more magnitude orders when the material passes from the amorphous phase (more resistive) to the polycrystalline phase (more conductive) and vice versa. The characteristics of chalcogenides in the two phases are shown in Figure 1. As may be noted, at a given read voltage, here designated by Vr, there is a resistance variation of more than 10.

Phase change may be obtained by locally increasing the temperature, as shown in Figure 2. Below 150°C both phases are stable. Above 200°C (temperature of start of nucleation, designated by Tₓ), fast nucleation of the crystallites takes place, and, if the material is kept at the crystallization temperature for a sufficient length of time (time t₂), it changes its phase and becomes crystalline. To bring the chalcogenide back into the amorphous state, it is necessary to raise the temperature above the melting temperature Tₘ (approximately 600°C) and then to cool the chalcogenide off rapidly (time t₁).

From the electrical standpoint, it is possible to reach both critical temperatures, namely the crystallization temperature and the melting point, by causing a current to flow through a resistive element which heats the chalcogenic material by the Joule effect.

The basic structure of a PCM element 1 which operates according to the principles described above is shown in Figure 3 and comprises a resistive element 2 (heater) and a programmable element 3. The programmable element 3 is made of a chalcogenide and is normally in the polycrystalline state in order to enable a good flow of current. One part of the programmable element 3 is in direct contact with the resistive element 2 and forms the area affected by phase change, hereinafter referred to as the phase change portion 4.

If an electric current having an appropriate value is caused to pass through the resistive element 2, it is possible to heat the phase change portion 4 selectively up to the crystallization temperature or to the melting temperature and to cause phase change. In particular, if a current I flows through a resistive element 2 having resistance R, the heat generated is equal to I²R.

The use of the PCM element of Figure 3 for forming memory cells has already been proposed. In order to prevent noise caused by adjacent memory cells, the PCM element is generally associated to a selection element, such a MOS transistor, a bipolar transistor, or a diode.

All the known approaches are, however, disadvantageous due to the difficulty in finding solutions that meet present requirements as regards capacity for withstanding the operating currents and voltages, as well as functionality and compatibility with present CMOS technologies.

In particular, considerations of a technological and electrical nature impose the creation of a contact area of small dimensions, preferably 20 nm x 20 nm, between the chalcogenic region and a resistive element. However, these dimensions are much smaller than those that can be obtained with current optical (UV) lithographic techniques, which scarcely reach 100 linear nm.

To solve the above problem, patent application 01128461.9, filed on 5.12.2001, having the publication number EP 1 318 552 A1 and entitled "Small area contact region, high efficiency phase change memory cell, and manufacturing method thereof", teaches forming the contact area as an intersection of two thin portions extending transversely with respect to one another and each of a sublithographic size. In order to form the thin portions, deposition of layers is adopted instead of a lithographic process, given that deposition makes it possible to obtain very thin layers, i.e., having a thickness much smaller than the current minimum size that can be achieved using lithographic techniques.

For a better understanding of the problem of the present invention, the manufacturing process object of the above mentioned patent application No. 01128461.9 will now be described.

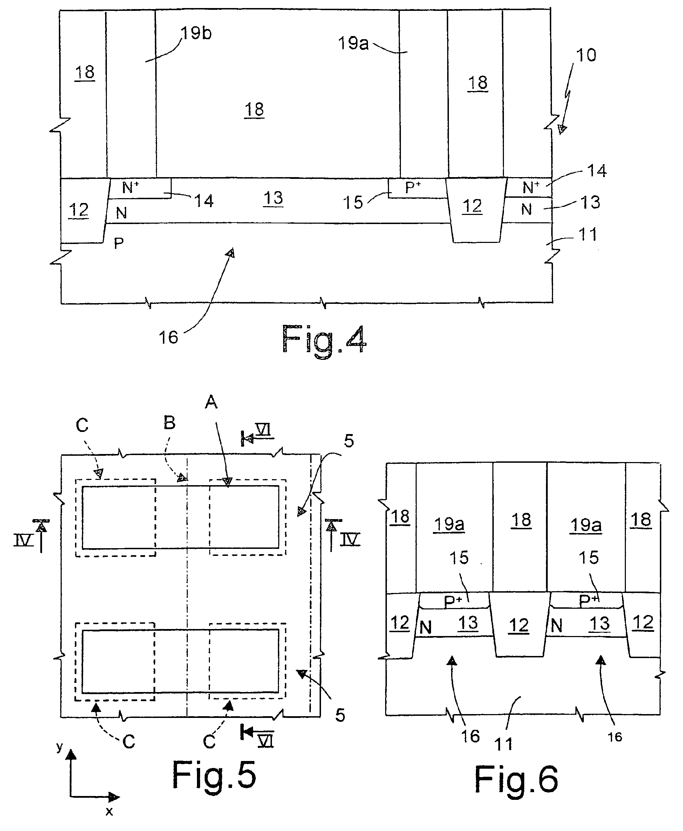

With reference to Figure 4, initially a wafer 10 comprising a P-type substrate 11 is subjected to standard front end steps. In particular, inside the substrate 11 insulation regions 12 are formed and delimit active areas 16; then, in succession, N-type base regions 13, N⁺-type base contact regions 14, and P⁺-type emitter regions 15 are implanted. The base regions 13, base contact regions 14, and emitter regions 15 form diodes that form selection elements for the memory cells.

Next, a first dielectric layer 18 is deposited and planarized; openings are formed in the first dielectric layer 18 above the base contact regions 13 and emitter regions 15, and the openings are filled with tungsten to form base contacts 19b and emitter contacts 19a. The base contacts 19b are thus in direct electrical contact with the base contact regions 13, and the emitter contacts 19a are in direct electrical contact with the emitter regions 15. Advantageously, the openings in the first dielectric layer 18 can be covered by a barrier layer, for example a Ti/TiN layer, before being filled with tungsten. In this way, the structure of Figure 4 is obtained.

Figure 5 shows the layout of some masks used for forming the structure of Figure 4 regarding a pair of memory cells 5 that are adjacent in a perpendicular direction to the sectional plane of Figure 4 (Y direction). In particular, the figure shows a mask A used for defining the active areas 16, a mask B used for implanting the emitter regions 15, and a mask C for forming the openings where the base contacts 19b and the emitter contacts 19a are to be formed. Figure 4 is a cross-section taken along line IV-IV of Figure 5, while Figure 6 shows the same structure sectioned along the section line VI-VI of Figure 5.

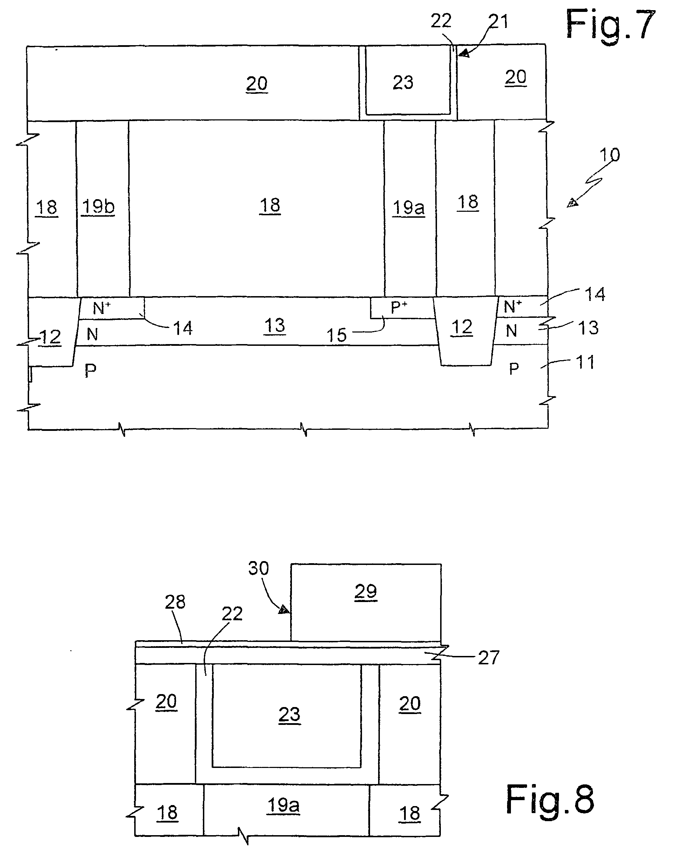

Next (Figure 7), a second dielectric layer 20 -for example, an undoped silicon glass (USG) layer- is deposited, and openings 21 are formed in the second dielectric layer 20 above the emitter contact 19a. The openings 21 have dimensions dictated by the lithographic process and are, for example, circle-shaped. Next, a heating layer, for example of TiSiN, TiAlN or TiSiC, is deposited for a thickness of 10-50 nm, preferably 20 nm. The heating layer, designed to form the resistive element 2 of Figure 3, conformally coats the walls and bottom of the openings 21 and is subsequently removed outside the openings 21. The remaining portions of the heating layer thus form a cup-shaped region 22 and are then filled with dielectric material 23.

Next, as shown in the enlarged detail of Figure 8, a mold layer 27, for instance USG having a thickness of 20 nm, an adhesion layer 28, for instance Ti or Si with a thickness of 5 nm, and a first delimiting layer 29, for example nitride or another material that enables selective etching with respect to the adhesion layer 28, are deposited in sequence. The first delimiting layer 29 has a thickness of, for instance, 150 nm. Then, using a mask, one part of the first delimiting layer 29 is removed by dry etching to form a step which has a vertical side 30 that extends vertically on top of the dielectric material 23. The structure shown in Figure 8 is thus obtained.

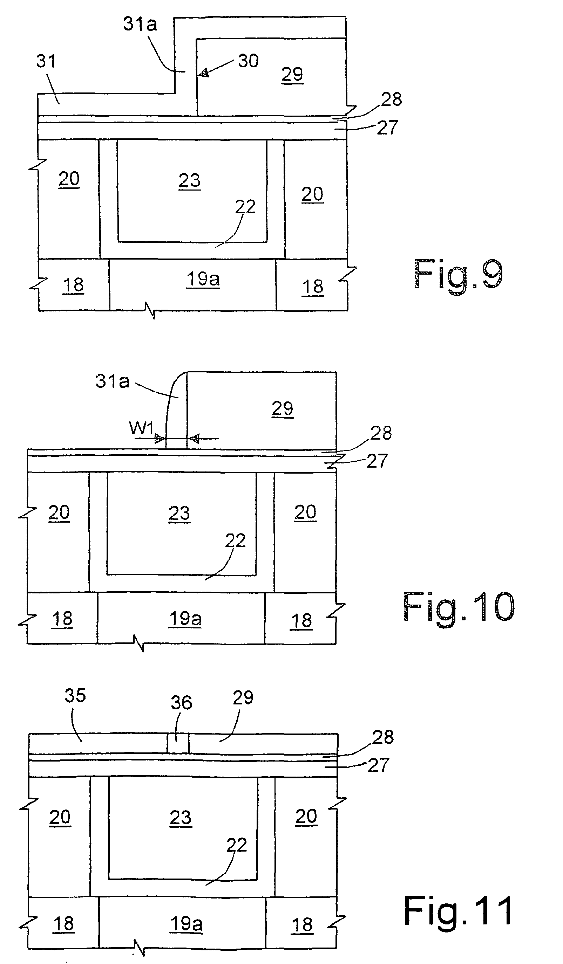

Next (Figure 9), a sacrificial layer 31, for example TiN with a thickness of 30 nm, is deposited conformally. In particular, the sacrificial layer forms a vertical wall 31a that extends along the vertical side 30 of the first delimiting layer 29.

Next (Figure 10), the sacrificial layer 31 is undergoes an etch back that results in removal of the horizontal portions of the sacrificial layer 31 and of part of the vertical wall 31a. By appropriately choosing the thickness of the first delimiting layer 29 and the thickness of the sacrificial layer 31, as well as the time and type of etching, it is possible to obtain the desired sublithographic width W1 for the bottom part of the remaining vertical wall 31a.

As shown in Figure 11, a second delimiting layer 35, of the same material as the first delimiting layer 29, for example nitride, with a thickness of 300 nm, is deposited. Next, the delimiting layers 29, 35 and the vertical wall 31a are thinned by chemical mechanical polishing (CMP). At the end, the remaining portions of the delimiting layers 29, 35 form a hard mask, and the remaining portion of the vertical wall forms a sacrificial region 36.

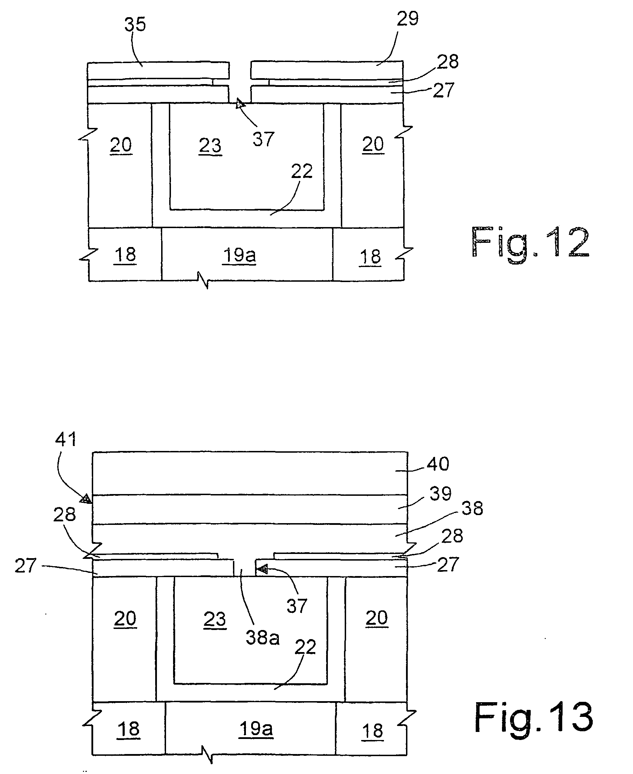

Next (Figure 12), the sacrificial region 36 is removed. The adhesion layer 28 is isotropically etched, and the mold layer 27 is dry etched to form a slit 37 in the mold layer 27, the slit 37 having a width W1 equal to the width of the sacrificial region 36.

Next (Figure 13), the delimiting layers 29, 35 are removed, and a chalcogenic layer 38, for example of Ge₂Sb₂Te₅ with a thickness of 60 nm, is deposited conformally. The portion 38a of the chalcogenic layer 38 fills the slit 37 and forms, at the intersection with the cup-shaped region 22, a phase change region similar to the phase change portion 4 of Figure 3. Then, on top of the chalcogenic layer 38 a barrier layer 39, for example of Ti/TiN, and a metal layer 40, for example of AlCu, are deposited. The structure of Figure 13 is thus obtained.

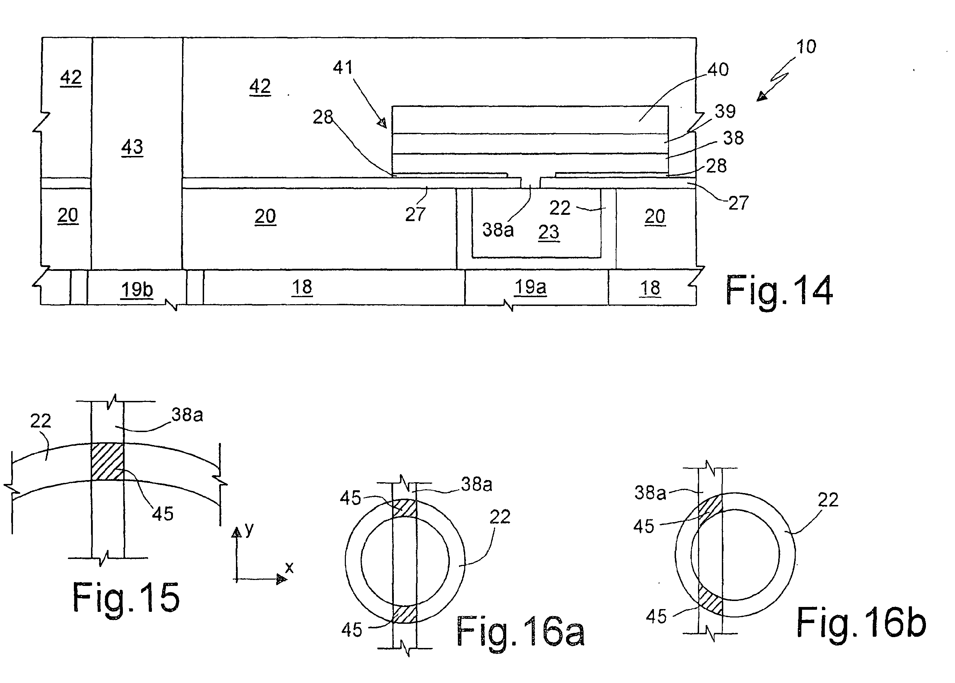

Next (Figure 14), the stack formed by the metal layer 40, barrier layer 39, chalcogenic layer 38, and adhesion layer 28 is defined using a same mask to form a bit line 41. Finally, a third dielectric layer 42 is deposited, which is opened above the base contacts 19b. The openings thus formed are filled with tungsten to form top contacts 43 in order to prolong upwards the base contacts 19b. Then standard steps are performed for forming the connection lines for connection to the base contacts 19b and to the bits lines 41, and the final structure of Figure 14 is thus obtained.

In practice, as shown in Figure 15, the intersection between the cup-shaped region 22 and the thin portion 38a of the chalcogenic layer 38 forms a contact area 45 which is approximately square and has sublithographic dimensions. This is due to the fact that both the cup-shaped region 22 and the thin portion 38a have a width equal to the thickness of a deposited layer. In fact, the width of the cup-shaped region 22 is given by the thickness of the heating layer, and the width of the thin portions 38a is determined by the thickness of the sacrificial layer 31 along the vertical side 30. In greater detail, in the proximity of the contact area 45, the cup-shaped region 22 has a sublithographic dimension in a first direction (Y direction), and the thin portion 38a has a sublithographic dimension (width W1 of Figure 10) in a second direction (X direction) which is transverse to the first direction. Hereinafter, the term "sublithographic dimension" means a linear dimension smaller than the limit dimension achievable with current optical (UV) lithographic techniques, and hence smaller than 100 nm, preferably 50-60 nm, down to approximately 20 nm.

In the process described above, forming the thin portion 38a of the chalcogenic layer 38 entails numerous steps and is somewhat complex. Consequently, it is desirable to avail a simpler alternative process.

In addition, the dimensions of the contact area 45 depend upon the alignment tolerances between the mask used for forming the openings 21 and the mask used for removing part of the first delimiting layer 29 and for forming the vertical side 30 (Figure 8). In fact, as emerges clearly from a comparison between Figures 16a and 16b which are top plan views of the contact area 45, in the case of a cup-like region 22 having a circular shape and a diameter of approximately 0.2 µm, an alignment error of even only 0.05 µm between the two masks results in the thin portions 38a no longer crossing the cup-shaped regions 22 perpendicularly, with a consequent considerable increase in the dimensions of the contact area 45 (see Figure 16b) and hence a considerable increase in the flowing current, the value whereof would be uncontrollable.

Furthermore, the thin portion 38a crosses each cup-shaped region 22 in two points, thus doubling the total contact area between the thin portions 38a and the cup-shaped regions 22, and consequently also increasing the programming current. In the case of a marked misalignment between the two above masks, just one contact area is even obtained which has dimensions far greater than the requirements. The presence of a double contact gives rise to functional problems, given that in this situation it would be impossible to know which of the two contact areas 45 first causes switching of the overlying thin portion 38a (i.e., the phase change portion), nor would it be possible to be certain that both of the thin portions 38a overlying the two contact areas will switch.

US 6 031 287 A discloses a phase change memory cell comprising a resistive element formed by a thin layer deposited in a trench whose upper edge is in contact with a linear memory region of phase change material extending transversely to the upper edge.

US 2002/017701 A1 discloses a phase change memory cell having a planar resistive layer and a memory region of a phase change material formed in a pore or in a trench and in direct electrical contact with the planar resistive layer. The pore or trench is formed in an opening of a dielectric layer overlying the planar resistive layer. The opening has a spacer formed on the sidewalls to delimit the pore or trench so that the memory region in contact with the planar resistive layer may have a sublithographic width.

The aim of the present invention is to simplify and improve the process described in patent application 01128461.9, with particular regard to forming the thin portion 38a.

According to the present invention there are provided a phase change memory cell and a manufacturing process thereof, as defined in claims 1 and 7, respectively.

For a better understanding of the present invention, a preferred embodiment thereof is now described, purely by way of non-limiting example, with reference to the attached drawings, in which:
- Figure 1 shows the current versus voltage characteristic of a phase change material;
- Figure 2 shows the temperature versus current plot of a phase change material;
- Figure 3 shows the basic structure of a PCM memory element;
- Figure 4 shows a cross section of a wafer of semiconductor material in a manufacturing step of the cell of Figure 3, according to the aforementioned patent application;
- Figure 5 shows the layout of some masks used for forming the structure of Figure 4;
- Figure 6 is a cross-section taken along line VI-VI of Figure 5;
- Figures 7-14 are cross-section of the structure of the above mentioned patent application, in successive manufacture steps;
- Figure 15 is a top plan view, with parts removed and at an enlarged scale, of a detail of Figure 4;
- Figures 16a and 16b are top plan views, with parts removed, of a detail of Figure 14, in two different manufacture conditions;
- Figure 17 shows the layout of some masks used for forming the structure of Figure 7, according to the invention;
- Figure 18 is a cross-section similar to Figure 8, in a manufacture step according to the invention;
- Figure 19 shows the layout of some masks used for forming the structure of Figure 18;
- Figures 20 and 21 are cross-sections, similar to Figure 18, in successive manufacture steps according to the invention;
- Figure 22 is a top plan view of the structure of Figure 21;
- Figure 23 is a cross-section, similar to Figure 21, in a subsequent manufacture step;
- Figure 24 shows the layout of same masks used for forming the structure of Figure 23;
- Figure 25 is a cross-section, similar to Figure 14, in a final manufacture step according to the invention;
- Figures 26a and 26b are top plan views of the contact area, in two different manufacture conditions; and
- Figures 27 and 28 show two steps regarding a different embodiment.

In the following description, parts that are the same as those previously described with reference to Figures 4-14 are designated by the same reference numbers.

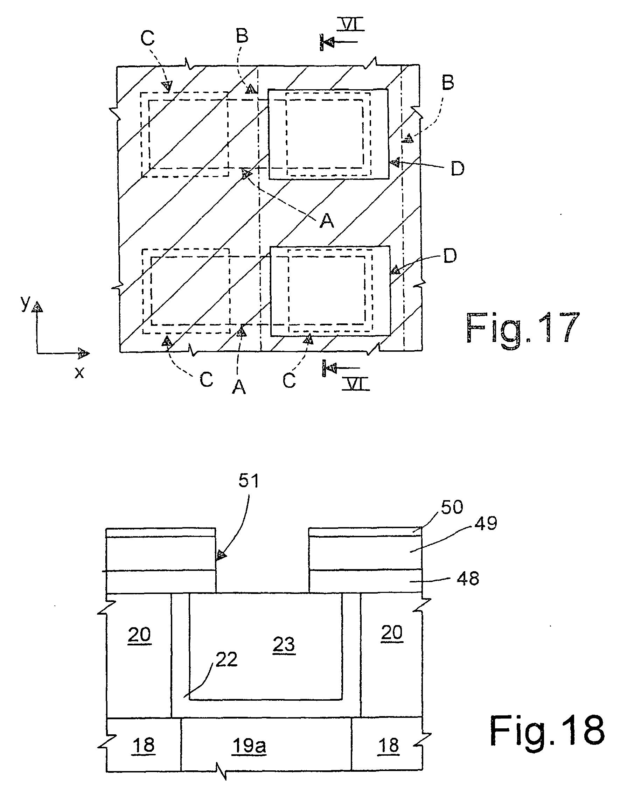

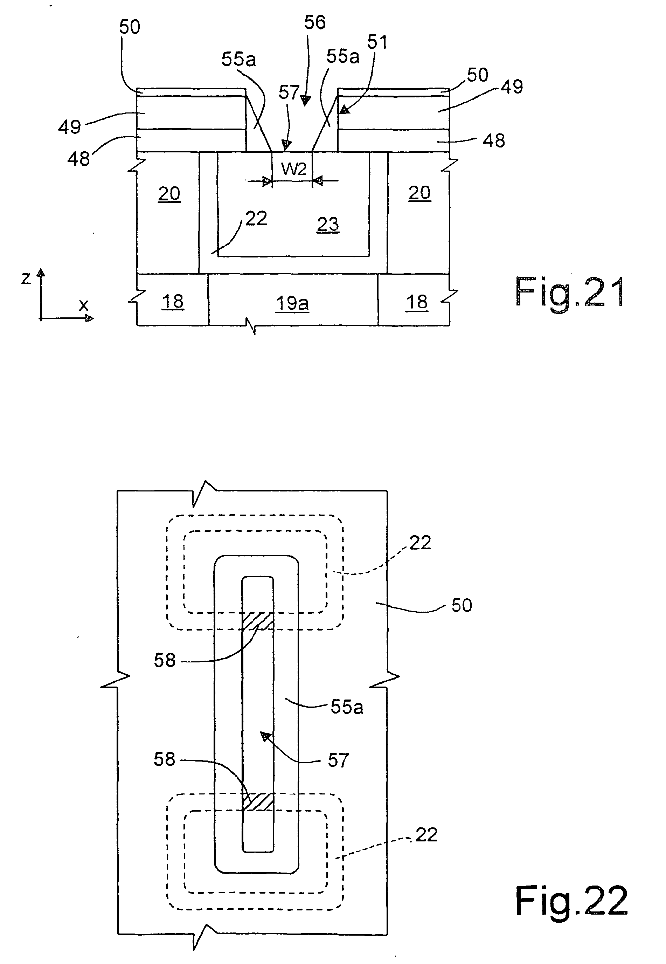

The process according to the present invention comprises initial steps equal to those described in patent application 01128461.9 illustrated above, up to deposition of the second dielectric layer 20 (Figure 7). Next, also here the openings 21 and the cup-shaped regions 22 are formed. However, as shown in Figure 17, for the definition of the openings 21, a heater mask D is used which has rectangular windows (the term "rectangular" also comprising the particular case of a square shape). Consequently, the openings 21 have a substantially rectangular shape. Then the heating layer, for example of TiSiN, TiAlN or TiSiC, with a thickness of 10-50 nm, preferably 20 nm, is deposited. The heating layer coats the walls and bottom of the openings 21 conformally. Consequently, in top plan view, the cup-like regions 22 here define an ideally rectangular shape, possibly with rounded edges (on account of the lithographic limits), or at the most an ovalized shape, with the longer side, or main direction, parallel to the X direction (Figure 22). Next, the heating layer is removed outside the openings 21 to form the cup-shaped regions 22, which are then filled with the dielectric material 23.

Then (Figure 18), a stop layer 48, for example of nitride deposited by PECVD (Plasma Enhanced Chemical Vapor Deposition) with a thickness of 40 nm, a mold layer 49, for example of USG deposited by PECVD or SACVD (Sub-Atmospheric Chemical Vapor Deposition) with a thickness of 50-70 nm, and an adhesion layer 50, for example of Ti or Si with a thickness of 20-40 nm, are deposited in sequence.

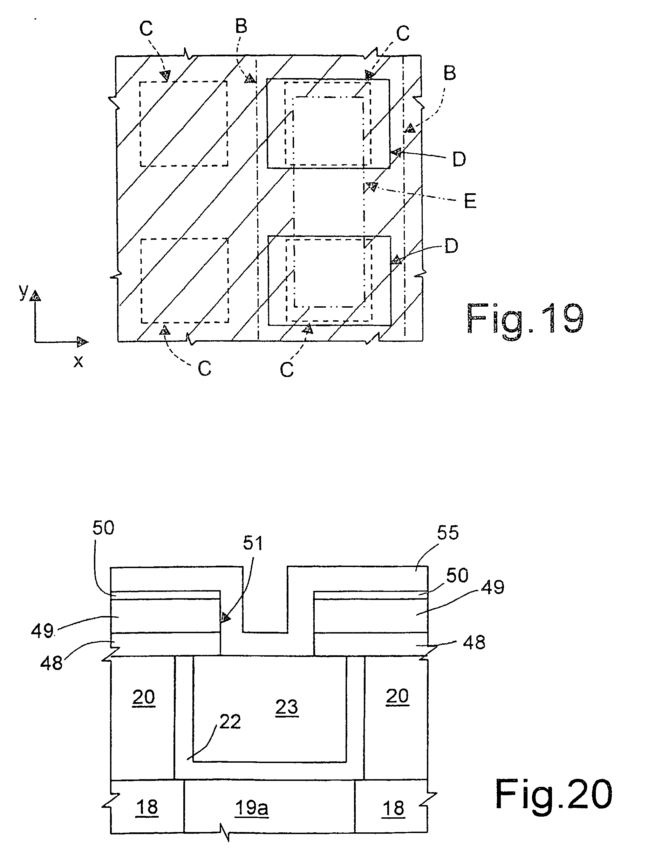

Next, using a minitrench mask, designated by E in Figure 19, the adhesion layer 50, the mold layer 49 and the stop layer 48 are etched. As shown in Figure 19, the minitrench mask E has a rectangular window that extends between two adjacent cells 5 in the Y direction (perpendicular to the alignment direction of the base and emitter regions 14, 15 of each memory cell 5, Figure 7).

Following upon etching, part of the layers 48, 49 and 50 is removed, so as to form an opening 51 having a rectangular shape, corresponding to that of the minitrench mask E. The width of the opening 51 in the X direction is, for example, 160 nm. The opening 51 uncovers part of the dielectric material 23 of the two adjacent cells 5 and crosses each cup-shaped region 22 only once, as can be clearly seen from the superposition of the heater mask D and minitrench mask E in Figure 19.

Next, Figure 20, a spacer layer 55, for example an oxide layer, is deposited (in particular, TEOS with a thickness of 50 nm). The spacer layer 55 covers the adhesion layer 50, as well as the walls and bottom of the opening 51.

Then, Figure 21, the spacer layer 55 is anisotropically etched by etching back until the horizontal portions thereof are removed, according to the well known spacer formation technique. The spacer layer 55 is then completely removed above the adhesion layer 50 and is partially removed from the bottom of the opening 51 to form a spacer region 55a which extends along the vertical sides of the opening 51 (along the perimeter of a rectangle or of an oval) and delimits a slit 56, the base whereof forms a rectangular strip 57 having a sublithographic width W2 (in the X direction) of approximately 60 nm. Figure 22 is a top plan view of the structure thus obtained, and highlights how the strip 57 uncovers only one portion of the cup-shaped region 22 of each cell 5, shown with dashed line in the figure. The uncovered portion of each cup-shaped region 22 forms a contact area 58, as will be explained hereinafter.

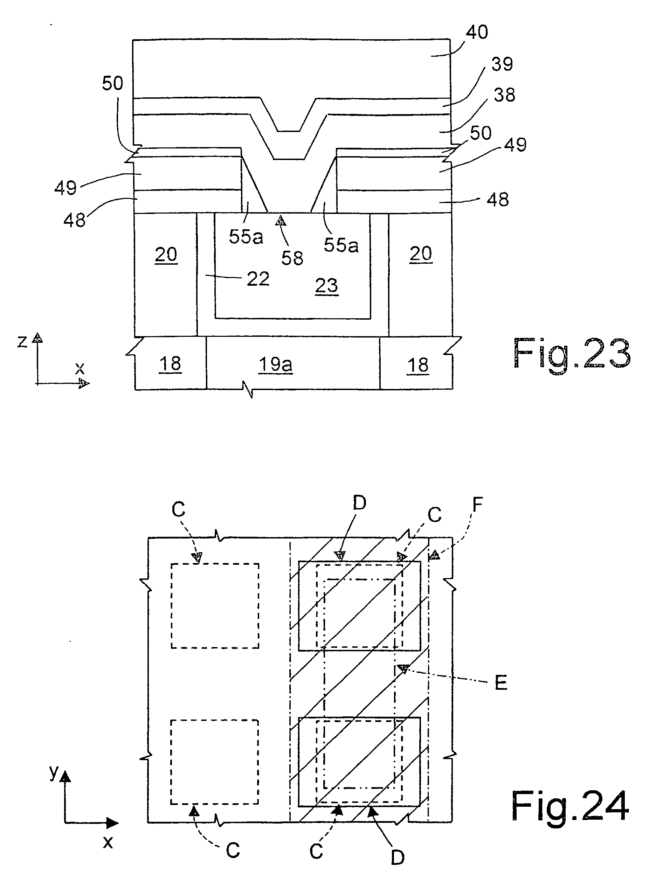

Next, Figure 23, the chalcogenic layer 38 (also in the present case, for instance, of Ge₂Sb₂Te₅ with a thickness of 60 nm), the barrier layer 39, and the metal layer 40 are deposited in succession, to form a stack of layers 41. The chalcogenic layer 38 is in direct contact with the adhesion layer 50, to which it adheres properly, and fills the slit 56 with a thin portion 38a. In particular, the thin portion 38a of the chalcogenic layer 38 deposits on the strip 57, contacting the cup-shaped regions 22 at the contact areas 58. The inclined wall formed by the spacer region 55a favors filling of the slit 56, so preventing problems linked to a poor aspect ratio of the opening 51.

Next, the stack of layers 41 is defined using a stack mask F (Figure 24).

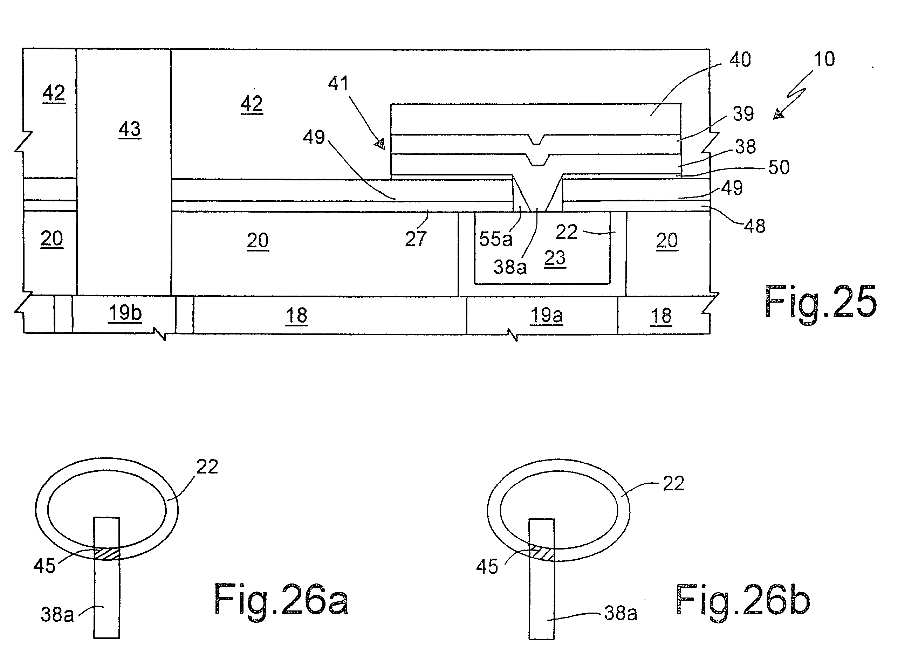

The process continues with the steps described previously, which comprise deposition of the third dielectric layer 42, opening of the third dielectric layer 42 above the base contacts 19b, formation of the top contacts 43, and formation of connection lines for connection to the base contacts 19b and to the bit lines 41, so as to obtain the final structure shown in Figure 25.

The advantages of the process and structure described herein are illustrated hereinafter. First, the sequence of steps required for forming the thin portion 38a is simplified, and the chalcogenic layer 38 adheres perfectly to the underlying layers and fills the opening 51 correctly, thanks to the inclination of the spacer region 55a, as already mentioned previously.

Furthermore, the shape of the minitrench mask E makes it possible to obtain a single contact area 58 for each cup-shaped region 22, and hence for each cell 5, without requiring any additional masking steps.

The rectangular or ovalized shape of the cup-shaped region 22 reduces the spread in the dimensions of the contact area 58 also when its shape, instead of being rectangular as in the ideal case, is oval, as may be seen from a comparison between Figure 26a, which shows the position of the cup-shaped region 22 with respect to thin region 38a in the absence of mask misalignment, and Figure 26b, which shows the relative position in presence of misalignment.

Finally, it is clear that numerous modifications and variations may be made to the process and to the memory cell described and illustrated herein, all falling within the scope of the invention, as defined in the attached claims. For example, the sequence of steps required for forming the spacer region 55a and of the strip 57 may vary. In particular, for forming the opening 51 it is possible to etch the adhesion layer 50 and the mold layer 49 alone, without removing the stop layer 48. Next, the spacer region 55a is formed in the way described previously, by depositing a spacer layer and etching it anisotropically. Finally, the stop layer 48 is removed only where it is not covered by the spacer region 55a, and in this way the strip 57 is uncovered.

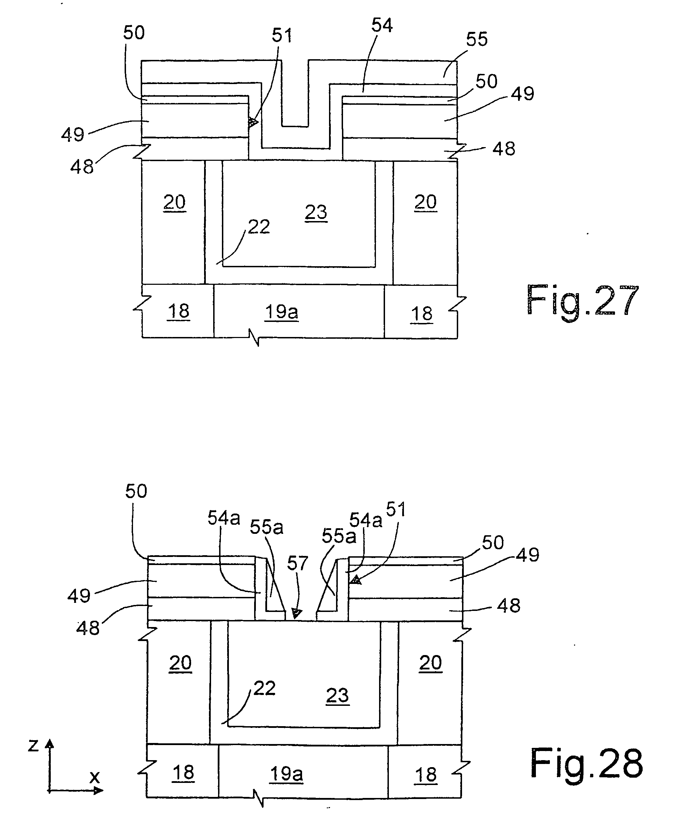

In addition, according to a different embodiment, after forming the opening 51 (Figure 18) and before depositing the spacer layer 55, a protective layer 54, of silicon nitride, may be deposited, as shown in Figure 27. The protective layer 54, preferably deposited by PECVD, has, for instance, a thickness of between 20 and 30 nm. Next, etching back is performed to remove the horizontal portions of the spacer layer 55 and then the horizontal portions of the protective layer 54. A protective portion 54a thus is left only beneath the spacer region 55a, as shown in Figure 28. The protective layer 54 protects the adhesion layer 50 and prevents contamination thereof by the spacer layer 55, which is of oxide, both at the top and at the sides. In addition, it functions as an etch stop and prevents undesired etching of the dielectric layer 20 and of the dielectric material 23 during etching back for forming the spacer region 55a.

According to a further embodiment, after depositing the adhesion layer 50 and before etching using the minitrench mask E, a further nitride layer having a thickness of 20-30 nm is deposited. Then, using the minitrench mask E, the further nitride layer, the adhesion layer 50, and the mold layer 49 are selectively removed, without the stop layer 48 being removed. The spacer layer 55 is deposited, and an etch back is performed for forming the spacer region 55a. Next, a nitride etch is carried out, removing the horizontal portions of the further nitride layer above the adhesion layer 55, and the exposed portion of the stop layer 48. Then the other steps of depositing the chalcogenic layer 38, and so forth, follow. In this way, the further nitride layer protects the adhesion layer 50 from any possible contamination by the spacer layer 55.

## Claims

1. A phase change memory cell comprising:
a resistive element (22) having a cup-like shape including a first vertical wall defining a first thin portion having a first sublithographic dimension, smaller than 100 nm, in a first direction (Y); and
a memory region (38) of a phase change material and including a second thin portion (38a) having a second sublithographic dimension, smaller than 100 nm, in a second direction (X) transverse to said first direction;
said resistive element (22) and said memory region (38) being in direct electrical contact at said first and second thin portions (22, 38a) and defining a contact area (58) of sublithographic extension, smaller than 0.01 µm²,
wherein said second thin portion (38a) is delimited laterally, at least in said second direction, by spacer portions (55a) of a first dielectric material in direct contact with said first thin portion, said spacer portions delimiting an elongated slit (56) having rectangular base (57) whose width has said second sublithographic dimension and defining inclined surfaces in a third direction, transverse to said first and second directions.

2. The memory cell according to claim 1, wherein said spacer portions (55a) are surrounded by a mold layer (49) of a second dielectric material, forming a lithographic opening.

3. The memory cell according to claim 2, wherein said resistive element (22) is formed inside an insulating layer (20) of a third dielectric material, said mold layer (49) extends on top of said insulation layer, and a stop layer (48) of a fourth dielectric material extends between said insulating layer and said mold layer.

4. The memory cell according to claim 3, wherein said spacer portions (22) are of silicon dioxide, said mold layer (49) and said insulating layer are of a silicon glass, and said stop layer (48) is of silicon nitride.

5. The memory cell according to any one of claims 1 to 4, wherein said thin portion (38a) has a substantially elongated shape with a main dimension extending parallel to said first direction (Y).

6. A memory array comprising at least two memory cells (5) according to any of claims 1-5, each of which has a respective resistive element (22) including a first thin portion, said memory cells further comprising a common memory region (38) of a phase change material, said common memory region (38) comprising said second thin portion (38a);
wherein said memory cells (5) are adjacent to one another in said first direction;
the first thin region (22) of each resistive element is in direct electrical contact with said second thin region (38a) and defines a respective single contact area (58)

7. A process for manufacturing a phase change memory cell, the process comprising:
a resistive element (22) having a cup-like shape including a first vertical wall defining a first thin portion having a first sublithographic dimension, smaller than 100 nm, in a first direction (Y); and
forming a memory region (38) of a phase change material and including a second thin portion (38a) having a second sublithographic dimension, smaller than 100 nm, in a second direction (X) transverse to said first direction;
said first and second thin portion (22, 38a) defining a contact area (58) of sublithographic extension, smaller than 0.01 µm²;
wherein said step of forming a memory region (38) comprises forming a mold layer (49) on top of said resistive element (22); forming a first lithographic opening (51) in said mold layer; forming spacer portions (55a) in said first lithographic opening, said spacer portions being in direct contact with said first thin portion, having inclined surfaces in a third direction, transverse to said first and second directions, and defining an elongated slit (56) having a rectangular base (57) whose width has said second sublithographic dimension; and depositing a phase change layer (38) at least inside said slit.

8. The process according to claim 7, wherein said spacer portions (55a) are of a first dielectric material and said mold layer (49) is of a second dielectric material.

9. The process according to claim 7 or 8, wherein said step of forming a resistive element (22) comprises forming a second lithographic opening (21) in an insulating layer (20), depositing a conductive layer (22) on a side wall of said second lithographic opening, and filling (23) said second lithographic opening.

10. The process according to claim 8, wherein, before said step of forming a mold layer (49), a stop layer (48) of a third dielectric material is formed on top of said resistive element (22).

11. The process according to claim 10, wherein said spacer portions (55a) are of silicon dioxide, said mold layer (49) and said insulating layer (20) are of a silicon glass, and said stop layer (48) is of silicon nitride.

12. The process according to any one of claims 7 to 11, wherein said second thin portion (38a) has a substantially elongated shape and extends parallel to said first direction (Y).

13. The process according to any one of claims 7 to 12, wherein said step of forming spacer portions (55a) comprises, after said step of forming a first lithographic opening (51), the steps of depositing a spacer layer (55) and anisotropically etching said spacer layer.

14. The process according to any one of claims 7 to 13, wherein, before said step of forming a first lithographic opening (51), the step of depositing an adhesion layer (50) is carried out.

15. The process according to claims 13 and 14, wherein said step of forming spacer portions (55a) comprises depositing a protective layer (54), depositing said spacer layer (55), anisotropically etching said spacer layer, and selectively removing said protection layer above said adhesion layer (50) and at the sides of said spacer portions in said first lithographic opening.

16. A process for forming a pair of memory cells (5) adjacent in a first direction (Y) comprising the process according to any of claims 7-15, and further comprising the steps of:
forming a pair of resistive elements (22) each of which includes a first thin portion; and
forming a common memory region (38) of a phase change material and including said second thin portion (38a);
each resistive element forming, with said second thin portion, a respective contact area (58);
wherein said step of forming a common memory region (38) comprises forming said mold layer (49); forming said first lithographic opening (51) in said mold layer, said lithographic opening extending between said pairs of resistive elements (22) above said first thin portion of said pair of resistive elements; and forming said spacer portions (55a).

## Patentansprüche

1. Phasenänderungsspeicherzelle aufweisend:
ein Widerstandselement (22) mit einer becherartigen Form und mit einer ersten vertikalen Wand, die einen ersten dünnen Teilbereich mit einer ersten sub-lithographischen Abmessung, kleiner als 100nm, in einer ersten Richtung (Y) definiert; und
einen Speicherbereich (38) aus einem Phasenänderungsmaterial, welcher einen zweiten dünnen Teilbereich (38a) mit einer zweiten sub-lithographischen Abmessung, kleiner als 100nm, in einer zweiten Richtung (X) quer zu der ersten Richtung aufweist;
wobei das Widerstandselement (22) und der Speicherbereich (38) in direktem elektrischen Kontakt an dem ersten dünnen Teilbereich und dem zweiten dünnen Teilbereich (22, 38a) sind und eine Kontaktfläche (58) mit sub-lithographischer Ausdehnung, kleiner als 0.01 µm², definieren,
wobei der zweite dünne Teilbereich (38a) zumindest in der zweiten Richtung durch Abstandshalterteilbereiche (55a) aus einem ersten dielektrischen Material, die in direktem Kontakt mit dem ersten dünnen Teilbereich sind, lateral begrenzt ist, wobei die Abstandshalterteilbereiche einen langgestreckten Schlitz (56) mit rechteckiger Grundfläche (57) begrenzen, deren Breite die zweite sub-lithographische Abmessung hat, und geneigte Oberflächen in einer dritten Richtung, quer zu der ersten Richtung und der zweiten Richtung, definieren.

2. Speicherzelle gemäß Anspruch 1, wobei die Abstandshalterteilbereiche (55a) von einer Form-Schicht (49) aus einem zweiten dielektrischen Material umgeben sind, eine lithographische Öffnung bildend.

3. Speicherzelle gemäß Anspruch 2, wobei das Widerstandselement (22) innerhalb einer Isolierschicht (20) aus einem dritten dielektrischen Material ausgebildet ist, wobei die Form-Schicht (49) sich oben auf der Isolierschicht erstreckt und eine Stopp-Schicht (48) aus einem vierten dielektrischen Material sich zwischen der Isolierschicht und der Form-Schicht erstreckt.

4. Speicherzelle gemäß Anspruch 3, wobei die Abstandshalterteilbereiche (22) aus Siliziumdioxid sind, die Form-Schicht (49) und die Isolierschicht aus Siliziumglas sind und die Stopp-Schicht (48) aus Siliziumnitrid ist.

5. Speicherzelle gemäß irgendeinem der Ansprüche 1 bis 4, wobei der dünne Bereich (38a) eine im Wesentlichen langgestreckte Form hat mit einer Hauptausdehnung die sich parallel zu der ersten Richtung (Y) erstreckt.

6. Eine Speicheranordnung mit mindestens zwei Speicherzellen (5) gemäß irgendeinem der Ansprüche 1 bis 5, von denen jede ein jeweiliges Widerstandselement (22) aufweist mit einem ersten dünnen Teilbereich und wobei die Speicherzellen ferner
einen gemeinsamen Speicherbereich (38) aus einem Phasenänderungsmaterial aufweisen wobei der gemeinsame Speicherbereich den zweiten dünnen Teilbereich (38a) aufweist wobei die Speicherzellen (5) in einer ersten Richtung aneinander angrenzen;
wobei der erste dünne Bereich (22) jedes Widerstandselements in direktem elektrischen Kontakt mit dem zweiten dünnen Bereich (38a) ist und eine jeweilige einzelne Kontaktfläche (5 8) definiert.

7. Verfahren zum Herstellen einer Phasenändcrungsspeicherzelle, das Verfahren aufweisend:
Bilden eines Widerstandselements (22) mit einer becherartigen Form und mit einer ersten vertikalen Wand, die einen ersten dünnen Teilbereich mit einer ersten sub-lithographischen Abmessung, kleiner als 100nm, in einer ersten Richtung (Y) definiert; und
Bilden eines Speicherbereichs (38) aus einem Phasenänderungsmaterial mit einem zweiten dünnen Teilbereich (38a) mit einer zweiten sub-lithographischen Abmessung, kleiner als 100nm, in einer zweiten Richtung (X) quer zu der ersten Richtung;
wobei der erste dünne Teilbereich und der zweite dünne Teilbereich (22, 38a) eine Kontaktfläche (58) mit sub-lithographischer Ausdehnung, kleiner als 0,01µm², definieren;
wobei der Schritt des Bildens des Speicherbereichs (38) aufweist
Bilden einer Form-Schicht (49) oben auf dem Widerstandselement (22);
Bilden einer ersten lithographischen Öffnung (51) in der Form-Schicht;
Bilden von Abstandshalterteilbereichen (55a) in der ersten lithographischen Öffnung, wobei die Abstandshalterteilbereiche in direktem Kontakt mit dem ersten dünnen Teilbereich sind, geneigte Oberflächen in einer dritten Richtung, quer zu der ersten Richtung und der zweiten Richtung aufweisen und einen langgestreckten Schlitz (56) mit rechteckiger Grundfläche (57) definieren, deren Breite die zweite sub-lithographische Abmessung hat; und Abscheiden einer Phasenändcrungsschicht (38) mindestens innerhalb des Schlitzes.

8. Verfahren gemäß Anspruch 7, wobei die Abstandshalterteilbereiche (55a) aus einem ersten dielektrischen Material sind und die Form-Schicht (49) aus einem zweiten dielektrischen Material ist.

9. Verfahren gemäß Anspruch 7 oder 8, wobei der Schritt des Bildens eines Widerstandselements (22) das Bilden einer zweiten lithographischen Öffnung (21) in einer Isolierschicht (20), das Abscheiden einer leitenden Schicht (22) auf einer Seitenwand der zweiten lithographischen Öffnung und das Füllen (23) der zweiten lithographischen Öffnung aufweist.

10. Verfahren gemäß Anspruch 8, wobei vor dem Schritt des Bildens der Form-Schicht (49) eine Stopp-Schicht (48) aus einem dritten dielektrischen Material oben auf dem Widerstandselement (22) gebildet wird.

11. Verfahren gemäß Anspruch 10, wobei die Abstandshalterteilbereiche (55a) aus Siliziumdioxid sind, die Form-Schicht (49) und die Isolierschicht (20) aus Siliziumglas sind und die Stopp-Schicht (48) aus Siliziumnitrid ist

12. Verfahren gemäß irgendeinem der Ansprüche 7 bis 11, wobei der dünne Bereich (38a) eine im Wesentlichen langgestreckte Form hat und sich parallel zu der ersten Richtung (Y) erstreckt.

13. Verfahren gemäß irgendeinem der Ansprüche 7 bis 12, wobei der Schritt des Bildens von Abstandshalterteilbereichen (55a) nach dem Schritt des Bildens einer ersten lithographischen Öffnung (51) die Schritte des Bildens einer Abstandshalterschicht (55) und des anisotropen Ätzens der Abstandshalterschicht aufweist.

14. Verfahren gemäß irgendeinem der Ansprüche 7 bis 13, wobei vor dem Schritt des Bildens einer ersten lithographischen Öffnung (51) der Schritt des Abscheidens einer Adhäsionsschicht (50) ausgeführt wird.

15. Verfahren gemäß den Ansprüchen 13 und 14, wobei der Schritt des Bildens von Abstandshalterteilbereichen (55a) das Abscheiden einer Schutz-Schicht (54), das Abscheiden der Abstandshalterschicht (55), das anisotrope Ätzen der Abstandshalterschicht und das selektive Entfernen der Schutz-Schicht über der Adhäsison-Schicht (50) und an den Seiten der Abstandshalterteilbereiche in der ersten lithographischen Öffnung aufweist.

16. Verfahren zum Bilden eines Paares von Speicherzellen (5), die in einer ersten Richtung (Y) aneinander angrenzen aufweisend das Verfahren gemäß irgendeinem der Ansprüche 7 bis 15, und ferner aufweisend die Schritte:
Bilden eines Paares von Widerstandselementen (22), von denen jedes einen ersten dünnen Teilbereich aufweist und
Bilden eines gemeinsamen Speicherbereichs (38) aus einem Phasenänderungsmaterial, der den zweiten dünnen Teilbereich (38a) aufweist;
wobei jedes Widerstandselement mit dem jeweiligen zweiten dünne Bereich eine jeweilige einzelne Kontaktfläche (58) bildet,
wobei der Schritt des Bildens eines gemeinsamen Speicherbereichs (38) das Bilden der Form-Schicht (49); das Bilden der ersten lithographischen Öffnung (51) in der Form-Schicht, wobei sich die lithographische Öffnung zwischen den Paaren von Widerstandselementen (22) über dem ersten dünnen Teilbereich des Paares von Widerstandselementen erstreckt, und das Bilden der Abstandshalterteilbereiche (55a) aufweist.

## Revendications

1. Cellule de mémoire à changement de phase comprenant :
un élément résistif (22) ayant une forme de cuvette comprenant une première paroi verticale définissant une première portion fine ayant une première dimension sub-lithographique, inférieure à 100 nm, dans une première direction (Y) ; et
une région de mémoire (38) d'un matériau à changement de phase et comprenant une seconde portion fine (38a) ayant une seconde dimension sub-lithographique, inférieure à 100 nm, dans une deuxième direction (X) transversale à ladite première direction ;
ledit élément résistif (22) et ladite région de mémoire (38) étant en contact électrique direct au niveau desdites première et seconde portions fines (22, 38a) et définissant une zone de contact (58) d'extension sub-lithographique, inférieure à 0,01 µm²,
dans laquelle ladite seconde portion fine (38a) est délimitée latéralement, au moins dans ladite deuxième direction, par des portions d'espacement (55a) d'un premier matériau diélectrique en contact direct avec ladite première portion fine, lesdites portions d'espacement délimitant une fente allongée (56) ayant une base rectangulaire (57) dont la largeur a ladite dimension sub-lithographique et définissant des surfaces inclinées dans une troisième direction, transversale auxdites première et deuxième directions.

2. Cellule de mémoire selon la revendication 1, dans laquelle lesdites portions d'espacement (55a) sont entourées par une couche de moule (49) d'un deuxième matériau diélectrique, formant une ouverture lithographique.

3. Cellule de mémoire selon la revendication 2, dans laquelle ledit élément résistif (22) est formé à l'intérieur d'une couche isolante (20) d'un troisième matériau diélectrique, ladite couche de moule (49) s'étend sur le sommet de ladite couche d'isolation, et une couche d'arrêt (48) d'un quatrième matériau diélectrique s'étend entre ladite couche isolante et ladite couche de moule.

4. Cellule de mémoire selon la revendication 3, dans laquelle lesdites portions d'espacement (22) sont constituées de dioxyde de silicium, ladite couche de moule (49) et ladite couche isolante sont constituées d'un verre de silicium, et ladite couche d'arrêt (48) est constituée de nitrure de silicium.

5. Cellule de mémoire selon l'une quelconque des revendications 1 à 4, dans laquelle ladite portion fine (38a) a une forme sensiblement allongée avec une dimension principale s'étendant parallèlement à ladite première direction (Y).

6. Matrice mémoire comprenant au moins deux cellules de mémoire (5) selon l'une quelconque des revendications 1 à 5, dont chacune a un élément résistif respectif (22) comprenant une première portion fine, lesdites cellules de mémoire comprenant en outre une région de mémoire commune (38) d'un matériau à changement de phase, ladite région de mémoire commune (38) comprenant ladite seconde portion fine (38a),
dans laquelle lesdites cellules de mémoire (5) sont adjacentes les unes aux autres dans ladite première direction ;
la première région fine (22) de chaque élément résistif est en contact électrique direct avec ladite seconde région fine (38a) et définit une zone de contact unique respective (58).

7. Procédé de fabrication d'une cellule de mémoire à changement de phase, le procédé comprenant :
la formation d'un élément résistif (22) ayant une forme de cuvette comprenant une première paroi verticale définissant une première portion fine ayant une première dimension sub-lithographique, inférieure à 100 nm, dans une première direction (Y) ; et
la formation d'une région de mémoire (38) d'un matériau à changement de phase et comprenant une seconde portion fine (38a) ayant une seconde dimension sub-lithographique, inférieure à 100 nm, dans une deuxième direction (X) transversale à ladite première direction ;
lesdites première et seconde portions fines (22, 38a) définissant une zone de contact (58) d'extension sub-lithographique, inférieure à 0,01 µm²,
dans lequel ladite étape de formation d'une région de mémoire (38) comprend la formation d'une couche de moule (49) sur le sommet dudit élément résistif (22) ;
la formation d'une première ouverture lithographique (51) dans ladite couche de moule ;
la formation de portions d'espacement (55a) dans ladite première ouverture lithographique, lesdites portions d'espacement étant en contact direct avec ladite première portion fine, ayant des surfaces inclinées dans une troisième direction, transversale auxdites première et deuxième directions, et définissant une fente allongée (56) ayant une base rectangulaire (57) dont la largeur a ladite seconde dimension sub-lithographique ; et
le dépôt d'une couche à changement de phase (38) au moins à l'intérieur de ladite fente.

8. Procédé selon la revendication 7, dans lequel lesdites portions d'espacement (55a) sont constituées d'un premier matériau diélectrique et ladite couche de moule (49) est constituée d'un deuxième matériau diélectrique.

9. Procédé selon la revendication 7 ou 8, dans lequel ladite étape de formation d'un élément résistif (22) comprend la formation d'une seconde ouverture lithographique (21) dans une couche isolante (20), le dépôt d'une couche conductrice (22) sur une paroi latérale de ladite seconde ouverture lithographique, et le remplissage (23) de ladite seconde ouverture lithographique.

10. Procédé selon la revendication 8, dans lequel, avant ladite étape de formation d'une couche de moule (49), une couche d'arrêt (48) d'un troisième matériau diélectrique est formée sur le sommet dudit élément résistif (22).

11. Procédé selon la revendication 10, dans lequel lesdites portions d'espacement (55a) sont constituées de dioxyde de silicium, ladite couche de moule (49) et ladite couche isolante (20) sont constituées d'un verre de silicium, et ladite couche d'arrêt (48) est constituée de nitrure de silicium.

12. Procédé selon l'une quelconque des revendications 7 à 11, dans lequel ladite seconde portion fine (38a) a une forme sensiblement allongée et s'étend parallèlement à ladite première direction (Y).

13. Procédé selon l'une quelconque des revendications 7 à 12, dans lequel ladite étape de formation de portions d'espacement (55a) comprend, après ladite étape de formation d'une première ouverture lithographique (51), les étapes de dépôt d'une couche d'espacement (55) et de gravure de manière anisotrope de ladite couche d'espacement.

14. Procédé selon l'une quelconque des revendications 7 à 13, dans lequel, avant ladite étape de formation d'une première ouverture lithographique (51), l'étape de dépôt d'une couche d'adhérence (50) est réalisée.

15. Procédé selon les revendications 13 et 14,
dans lequel ladite étape de formation de portions d'espacement (55a) comprend le dépôt d'une couche protectrice (54), le dépôt de ladite couche d'espacement (55), la gravure de manière anisotrope de ladite couche d'espacement et le retrait de manière sélectif de ladite couche de protection au-dessus de ladite couche d'adhérence (50) et au niveau des côtés desdites portions d'espacement dans ladite première ouverture lithographique.

16. Procédé de formation d'une paire de cellules de mémoire (5) adjacentes dans une première direction (Y) comprenant le procédé selon l'une quelconque des revendications 7 à 15 et comprenant en outre les étapes consistant à :
former une paire d'éléments résistifs (22) dont chacun comprend une première portion fine ; et
former une région de mémoire commune (38) d'un matériau à changement de phase et comprenant ladite seconde portion fine (38a) ;
chaque élément résistif formant, avec ladite seconde portion fine, une zone de contact respective (58) ;
dans lequel ladite étape de formation d'une région de mémoire commune (38) comprend la formation de ladite couche de moule (49) ; la formation de ladite première ouverture lithographique (51) dans ladite couche de moule, ladite ouverture lithographique s'étendant entre lesdites paires d'éléments résistifs (22) au-dessus de ladite première portion fine de ladite paire d'éléments résistifs ; et la formation desdites portions d'espacement (55a).
